# EUROPEAN PATENT APPLICATION

(11) **EP 4 576 945 A1**
(43) Date of publication of application: **25.06.2025**
(21) Application number: 24216948.0
(22) Date of filing: 02.12.2024
(51) Int. Cl.: H05K 1/02, H05K 3/34

(54) **METHOD FOR ACCOMMODATING SUBSTRATE WARPAGE IN PRINTED CIRCUIT BOARD ASSEMBLIES**

(30) Priority: 20.12.2023 US 202318390701
(71) Applicant: Rockwell Collins, Inc., Cedar Rapids, IA 52498 (US)
(72) Inventor: MAYFIELD, James B., Cedar Rapids, 52403 (US); BAUER, John A., Marion, IA (US)
(74) Representative: Dehns

(57) **Abstract**

A method for managing warpage in printed circuit board (PCB) assemblies. In embodiments, the method includes providing a plurality of substrates, analyzing surface planarity of a sample size of the plurality of substrates, categorizing the analyzed surface planarity into at least two different categories, creating a solder volume profile for each of the at least two different categories, selecting one of the plurality of substrates for use in a PCB assembly, determining which solder volume profile is applicable to the selected one of the plurality of substrates, and using the applicable solder volume profile to mount an electronic device on the selected substrate. In use, the solder profile volumes are used to form conductive connections between electronic components and a substrate.

## Description

### TECHNICAL FIELD AND BACKGROUND

The present disclosure relates generally to methods for assembling printed circuit boards (PCBs), and more particularly, to methods for creating solder volume profiles for use during the assembly of PCBs including warped substrates.

Printed circuits board (PCB) assemblies generally include substrates to which electronic devices such as integrated circuits, transistors, diodes, resistors, capacitors, inductors, etc., are mounted. Substrates may be insulated dielectric substrates having an applied and etched surface copper foil forming conductor patterns used to provide circuit connections for parts of the PCB assembly. During assembly, the electronic devices may be bonded to the copper foil, typically by soldering, to form a conductive connective between the copper foil and the electronic devices.

PCB substrates may be manufactured in large quantities. As such, inherent with manufacturing processes, defects may occur. In the case of substrates, defects may materialize as warpage that results in a non-planar substrate surface. Electronic devices may have varying sizes and number of soldered connections. As the electronic device size and number of connections increases, planarity defects in the substrate affect the spacing between the electronic device and the substrate. For example, an electronic device positioned over a concave substrate warpage will be spaced farther from the substrate at the center as compared to the sides, whereas an electronic device positioned over a convex substrate warpage will be spaced closer to the substrate at the center as compared to the sides. In either case, the spacing between the electronic device and the substrate surface may not be consistent across the span of the electronic device.

Solutions have been developed to address the problem of substrate warpage. For example, substrates may be individually analyzed for warpage and solder volume adjusted accordingly to accommodate the warpage for each analyzed substrate. In another solution, an excess amount of solder applied consistently across the conductive connections may be used to ensure that at each point of attachment a conductive connection is formed. While such solutions address warpage, the former is particularly labor intensive, time consuming, and costly to implement, and the latter may cause adjacent connections to flow into each other during reflowing.

Therefore, what is needed is a solution for addressing substrate warpage that overcomes the disadvantages of current solutions.

### BRIEF SUMMARY

In one aspect, the inventive concepts according to the present disclosure are directed to a method for managing warpage in printed circuit board (PCB) assemblies. In embodiments, the method includes providing a plurality of substrates, analyzing surface planarity of a sample size of the plurality of substrates, categorizing the analyzed surface planarity into at least two different categories of surface planarity, creating a solder volume profile for each of the at least two different categories of surface planarity, selecting one of the plurality of substrates for use in a PCB assembly, determining the solder volume profile applicable to the selected one of the plurality of substrates, and mounting an electronic device to the selected substrate using the applicable solder volume profile.

In some embodiments, the at least two different categories of surface planarity include a concave surface planarity and a convex surface planarity.

In some embodiments, the solder volume profile is convex for the concave surface planarity, and the solder volume profile is concave for the convex surface planarity.

In some embodiments, the method further includes categorizing the analyzed surface planarity into three different categories of surface planarity, wherein the three different categories include a concave surface planarity, a convex surface planarity, and a planar surface, and creating a solder volume profile for each of the three different categories of surface planarity. In embodiments, the solder volume profile is convex for the concave surface planarity, the solder volume profile is concave for the convex surface planarity, and the solder volume profile is planar or substantially planar for the planar surface.

In some embodiments, each solder volume profile includes a plurality of adjacent solder connections.

In some embodiments, each solder connection includes at least one of solder paste and a solder preform.

In some embodiments, the electronic device and the solder volume profile have a corresponding number of solder connections.

In some embodiments, the sample size is no more than 50% of a total number of the plurality of substrates, and more preferably no more than 25%.

In some embodiments, the plurality of substrates are printed wiring boards (PWBs).

In another aspect, the inventive concepts according to the present disclosure are directed to a method for assembling a printed circuit board (PCB) assembly. In embodiments, the method includes providing a plurality of substrates, providing a plurality of electronic devices configured to be mounted on the substrates, analyzing surface planarity of a sample size of the plurality of substrates, categorizing the analyzed surface planarity into at least two different categories of surface planarity, and creating a solder volume profile for each of the at least two different categories of surface planarity, selecting one of the plurality of substrates for use in a PCB assembly. For each mounting location on the selected one of the plurality of substrates, the method continues with determining which solder volume profile is applicable to the mounting location, and concludes with implementing the applicable solder volume profile when mounting one of the electronic devices at the mounting location.

This summary is provided solely as an introduction to subject matter that is fully described in the following detailed description and drawing figures. This summary should not be considered to describe essential features nor be used to determine the scope of the claims. Moreover, it is to be understood that both the foregoing summary and the following detailed description are explanatory only and are not necessarily restrictive of the subject matter claimed.

### BRIEF DESCRIPTION OF THE DRAWINGS

Implementations of the inventive concepts disclosed herein may be better understood when consideration is given to the following detailed description thereof. Such description refers to the included drawings, which are not necessarily to scale, and in which some features may be exaggerated and some features may be omitted or may be represented schematically in the interest of clarity. Like reference numerals in the drawings may represent and refer to the same or similar element, feature, or function. In the drawings:
FIG. 1 is a flow diagram of a method for managing warpage in PCB assemblies, in accordance with example embodiments of this disclosure;
FIG. 2 is a flow diagram of a method for assembling a PCB assembly, in accordance with example embodiments of this disclosure; and
FIG. 3A-D illustrate schematically different surface planarity and corresponding solder volume profile for the surface planarity, in accordance with example embodiments of this disclosure.

### DETAILED DESCRIPTION

Before explaining at least one embodiment of the inventive concepts disclosed herein in detail, it is to be understood that the inventive concepts are not limited in their application to the details of construction and the arrangement of the components or steps or methodologies set forth in the following description or illustrated in the drawings. In the following detailed description of embodiments of the instant inventive concepts, numerous specific details are set forth in order to provide a more thorough understanding of the inventive concepts. However, it will be apparent to one of ordinary skill in the art having the benefit of the instant disclosure that the inventive concepts disclosed herein may be practiced without these specific details. In other instances, well-known features may not be described in detail to avoid unnecessarily complicating the instant disclosure. The inventive concepts disclosed herein are capable of other embodiments or of being practiced or carried out in various ways. Also, it is to be understood that the phraseology and terminology employed herein is for the purpose of description and should not be regarded as limiting.

As used herein, a letter following a reference numeral is intended to reference an embodiment of the feature or element that may be similar, but not necessarily identical, to a previously described element or feature bearing the same reference numeral (e.g., 1, 1a, 1b). Such shorthand notations are used for purposes of convenience only, and should not be construed to limit the inventive concepts disclosed herein in any way unless expressly stated to the contrary.

Further, unless expressly stated to the contrary, "or" refers to an inclusive or and not to an exclusive or. For example, a condition A or B is satisfied by anyone of the following: A is true (or present) and B is false (or not present), A is false (or not present) and B is true (or present), and both A and B are true (or present).

In addition, use of the "a" or "an" are employed to describe elements and components of embodiments of the instant inventive concepts. This is done merely for convenience and to give a general sense of the inventive concepts, and "a" and "an" are intended to include one or at least one and the singular also includes the plural unless it is obvious that it is meant otherwise.

Finally, as used herein any reference to "one embodiment" or "some embodiments" means that a particular element, feature, structure, or characteristic described in connection with the embodiment is included in at least one embodiment of the inventive concepts disclosed herein. The appearances of the phrase "in some embodiments" in various places in the specification are not necessarily all referring to the same embodiment, and embodiments of the inventive concepts disclosed may include one or more of the features expressly described or inherently present herein, or any combination of sub-combination of two or more such features, along with any other features which may not necessarily be expressly described or inherently present in the instant disclosure.

Broadly, embodiments of the inventive concepts disclosed herein are directed to methods for addressing substrate warpage when assembling PCB assemblies. As used herein, the term 'substrate' refers to any material or assembly on which one or more electronic devices may be mounted. In other words, the substrate may be a base that physically supports surface mounted, and in some case socketed, electronic devices. Substrates may be single-layer or multi-layered depending on the complexity of the assembly. As used herein, the term 'electronic device' refers to components that are surface mounted on a substrate, such as integrated circuits, transistors, resistors, diodes, etc.

Electronic devices may be mounted on the surface of a substrate by way of connection pads and generally by soldering. For example, for assembly, connectors of the electronic device may be aligned with connection pads provided on the surface copper of the substrate, and solder provided between the connectors and the connection pads may be reflowed to form conductive connections. Connection pads may include, but are not limited to, solder bumps formed from solder paste, solder paste elements, and solder preforms that may or may not be coined. Application of the connection pads may be performed by a printing process, electroplating methods, inkjet methods, screen printing methods, pick-and-place methods, stenciling, etc.

In use, the methods according to the present disclosure solve the technical problem of mounting an electronic device on a non-planar substrate while ensuring conductive contact at each of the respective connectors.

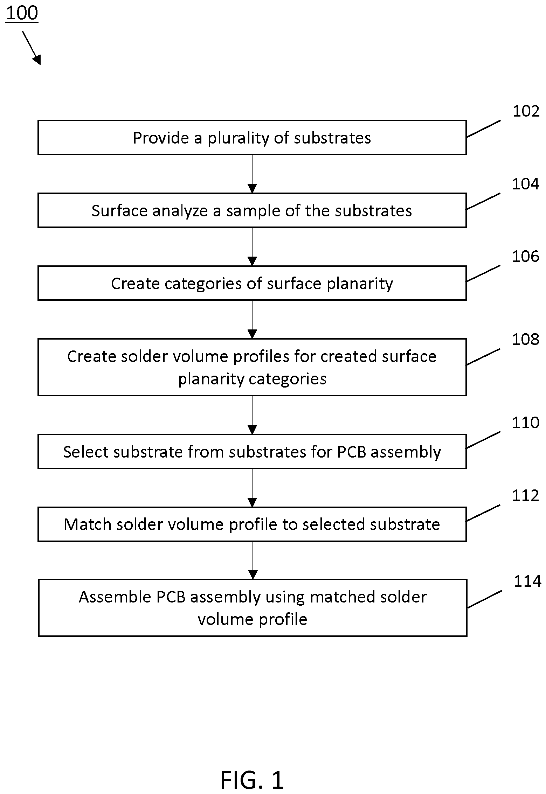

FIG. 1 illustrates a method 100 for managing warpage in PCB assemblies according to the present disclosure. At step 102, a plurality of substrates is provided on which at least one electronic device is to be mounted. In embodiments, each of the plurality of substrates may be part of the same lot, batch, or run, and therefore may be manufactured at the same time, according to the same manufacturing process, and under the same manufacturing conditions. While ideally each of the substrates is perfectly planar, manufacturing variance more often times produces at least some substrates that are non-planar (e.g., warped). Warpage may result in a surface that is concave, convex, combinations thereof, etc.

At step 104, a sampling less than the whole of the plurality of substrates is analyzed to determine surface planarity for each of the substrates of the sampling. For example, for a plurality of substrates, the sampling may be no more than about 50% of the total number of the plurality of substrates, or no more than about 25% of the total number of the plurality of substrates, or no more than about 15% of the total number of the plurality of substrates. For example, assuming a plurality of substrates including one-hundred substrates, about twenty of the substrates may be included in the sampling for analysis. The substrate analysis, used to inspect the surface planarity of the sampling, may be performed by visual inspection, x-ray inspection, or any other technique for determining the presence or absence of surface curvature.

At step 106, based on the results of the analysis of the sampling, the analyzed surface planarity is categorized into at least two different categories. For example, the different categories may include, but are not limited to, concave surface planarity and planar surface planarity, concave surface planarity and convex surface planarity, convex surface planarity and planar surface planarity, first concave surface planarity and second concave surface planarity (e.g., second being greater than first), and first convex surface planarity and second convex surface planarity (e.g., second being greater than first). In some embodiments, at least three different categories may be determined including a concave surface planarity category, a convex surface planarity category, and a planar surface planarity category. In other embodiments, at least five different categories may be determined including a planar or substantially planar category, a first concave surface planarity category, a second concave surface planarity category, a first convex surface planarity category, and a second convex surface planarity category.

In embodiments, each of the different surface planarity categories may correspond to a predefined range. For example, a planar surface category may include perfectly flat as well as a predefined curvature deviation in either direction from flat not exceeding a predefined threshold value. For example, a slight curvature that can be accommodated with a consistent solder volume profile may be categorized as planar, whereas a curvature in one direction that cannot be accommodated with a consistent solder volume profile may be categorized as a non-planar solder volume profile (e.g., concave or convex solder volume profile). In embodiments, a curvature that falls outside of any of the created surface planarity categories (e.g., too great a curvature in either direction) may be determined to be unusable in the particular PCB assembly of the method.

At step 108, the method continues with creating a solder volume profile for each of the at least two different categories of surface planarity. In embodiments, for the concave surface planarity category, the solder volume profile may be convex to counteract the concave substrate curvature to produce a substantially flat bonding surface for receiving the electronic device. For the convex surface planarity category, the solder volume profile may be concave to counteract the convex substrate curvature to produce a substantially flat bonding surface for receiving the electronic device. For the planar surface planarity, the solder volume profile may be substantially planar to maintain a planar bonding surface for receiving the electronic device. Other solder volume profiles may be created including complex and compound curvatures, curvatures that transition to plateaus, etc.

At step 110, the method continues with selecting one of the plurality of substrates for use in assembling a PCB assembly. At step 112, the method includes determining the solder volume profile applicable to the selected one of the plurality of substrates based on the determined surface planarity of that particular substrate. For example, if the selected substrate falls within the category of concave surface planarity, i.e., within the predefined threshold limits of being considered concave for that category, then the matching convex solder volume profile is selected, and vice versa. At step 114, the method continues with utilizing the applicable solder volume profile to mount the electronic device in a predetermined location on the selected one of the plurality of substrates. By matching the solder volume profile to the determined surface planarity, the method according to the present disclosure ensures conductive contact at each of the connectors of the mounted electronic device.

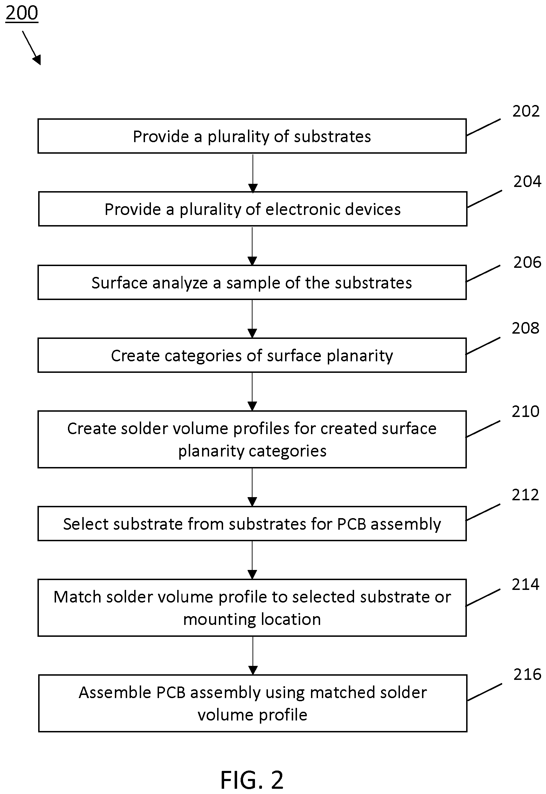

FIG. 2 illustrates a similar method 200 for assembling a PCB assembly. At step 202, the method includes providing a plurality of substrates, for example, as described above. At step 204, the method includes providing a plurality of electronic devices configured to be mounted on the substrates. In embodiments, each substrate may receive a single electronic device or more likely a plurality of electronic devices each at a predetermined mounting location on the substrate surface. At step 206, the method continues with analyzing surface planarity of a sample size of the plurality of substrates. In embodiments, the analysis may consider the substrate surface as a whole, predefined regions of the substrate, or the particular location of each particular electronic device.

At step 208, the method continues with categorizing the analyzed surface planarity into at least two different categories of surface planarity, and in some instance three different categories. As discussed above, the two different categories may include, but are not limited to, concave surface planarity and planar surface planarity, concave surface planarity and convex surface planarity, convex surface planarity and planar surface planarity, etc. In some embodiments, at least three categories include concave surface planarity, convex surface planarity, and planar surface planarity. In embodiments, each of the different surface planarity categories may be determined by exceeding a threshold value corresponding to a deviation from a predefined acceptable measurement. For instance, planar surface planarity may encompass perfectly flat as well as a minimal amount of curvature not exceeding a predefined threshold curvature in either direction. Surface planarity categories may be created for the substrate as a whole, for predefined regions on the substrate, or for each mounting location for each electronic device.

At step 210, the method continues with creating a solder volume profile for each of the at least two different categories of surface planarity as discussed above. At step 212, the method continues with selecting one of the plurality of substrates for use in a PCB assembly. At step 214, for each mounting location on the selected one of the plurality of substrates, the method continues with determining which solder volume profile is applicable to that particular mounting location. At step 216, the method continues with utilizing the applicable solder volume profile to mount one of the electronic devices at the mounting location. For example, a large format substrate may have a substantially planar center portion with increasing curvature in the direction of the sides. In that case, it may be appropriate to implement the planar solder profile for electronic components centrally mounted on the substrate and implement a different solder profile when mounting electronic devices closer to the edges of the substrate. In embodiments, the different solder volume profiles may be implemented separately or synchronously.

In embodiments, the same surface analysis, categorization, profile creation, and implementation may be used in connection with the surface planarity of the electronic device, or considering the surface planarity of each of the substrate and the electronic device. For example, the planarity of the substrate and the electronic device may be considered separately or together. In some embodiments, a substrate having a curvature in one direction may be matched with an electronic device having a curvature in the same direction to minimize the spacing therebetween and therefore the steepness of the volume profile needed to mound the device to ensure conductive connection. The conductive connections may be formed utilizing solder paste applied with a printing process or stencil as discussed above. For example, solder paste may be utilized in conjunction with solder balls aligned with the solder paste and connection pads, and the two elements bonded together during a reflow process in which the solder paste and solder balls are heated to flow to form conductive connections.

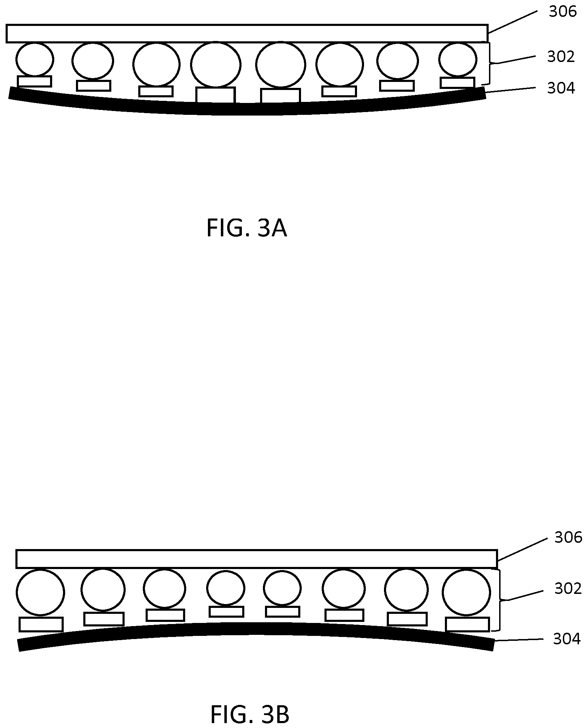

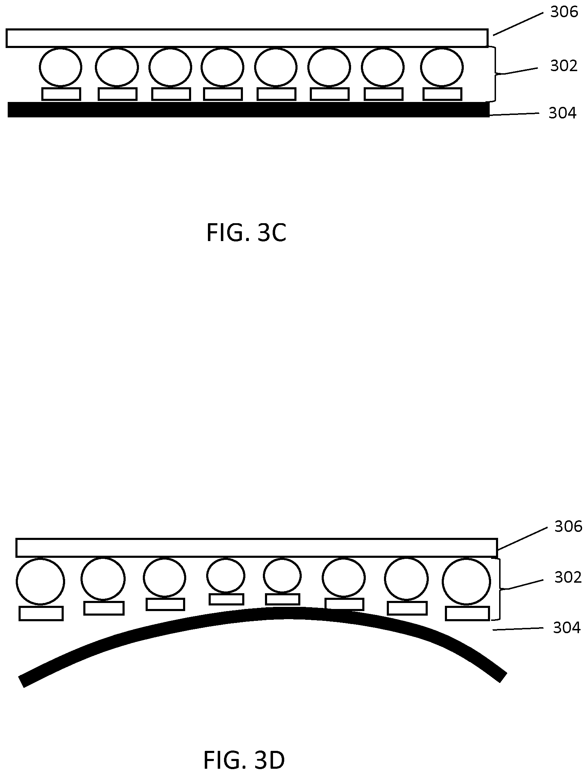

FIGS. 3A-D illustrate different solder volume profiles 302 compatible for use with the different determined surface planarities 304, and shown with a planar or substantially planar electronic component 306. FIG. 3A illustrates a convex solder volume profile 302, which has greater volume of solder provided at the center as compared to the sides, for accommodating a concave surface planarity 304. FIG. 3B illustrates a concave solder volume 302, which has a greater volume of solder provided at the sides as compared to the center. FIG. 3C illustrates a planar solder volume profile, which has a substantially consistent solder volume across the profile, for maintaining a planar bonding interface. FIG. 3D illustrates a substrate surface planarity that is not mitigatable with any solder volume profile, and thus the substrate is unusable for purposes of the PCB assembly.

From the above description, it is clear that the inventive concepts disclosed herein are well adapted to achieve the objectives and to attain the advantages mentioned herein as well as those inherent in the inventive concepts disclosed herein. While presently preferred embodiments of the inventive concepts disclosed herein have been described for purposes of this disclosure, it will be understood that numerous changes may be made which will readily suggest themselves to those skilled in the art and which are accomplished within the broad scope and coverage of the inventive concepts disclosed and claimed herein.

## Claims

1. A method for managing warpage in printed circuit board (PCB) assemblies, the method comprising:
providing a plurality of substrates;
obtaining, from the plurality of substrates, a sampling of substrates;
analyzing surface planarity of the sampling of substrates;
categorizing the analyzed sampling of substrates into at least two different categories of surface planarity;
creating a solder volume profile for each of the at least two different categories of surface planarity;
selecting one of the plurality of substrates for use in a PCB assembly;
determining the solder volume profile applicable to the selected one of the plurality of substrates; and
mounting an electronic device to the selected one of the plurality of substrates using the applicable solder volume profile.

2. The method according to claim 1, wherein the at least two different categories of surface planarity include a concave surface planarity and a convex surface planarity.

3. The method according to claim 2, wherein:
for the concave surface planarity, the solder volume profile is convex; and
for the convex surface planarity, the solder volume profile is concave.

4. The method according to any preceding claim, wherein the method further comprises:
categorizing the analyzed surface planarity into at least three different categories of surface planarity, wherein the at least three different categories include at least one concave surface planarity, at least one convex surface planarity, and a planar surface planarity; and
creating a solder volume profile for each of the at least three different categories of surface planarity, wherein:
for the at least one concave surface planarity, the solder volume profile is convex;
for the at least one convex surface planarity, the solder volume profile is concave; and
for the planar surface planarity, the solder volume profile is planar.

5. The method according to any preceding claim, wherein each solder volume profile includes a plurality of adjacent solder connections.

6. The method according to claim 5, wherein each solder connection includes at least one of solder paste and a solder preform.

7. The method according to any preceding claim, wherein the electronic device and the solder volume profile have a corresponding number of solder connections.

8. The method according to any preceding claim, wherein the sample size is no more than 50% of a total number of the plurality of substrates.

9. The method according to any of claims 1-7, wherein the sample size is no more than 25% of a total number of the plurality of substrates.

10. The method according to any preceding claim, wherein the plurality of substrates are single-layered or multi-layered.

11. The method according to any preceding claim, wherein the method is implemented to assemble printed circuit board (PCB) assemblies.
